# EUROPEAN PATENT APPLICATION

(11) **EP 4 716 453 A1**
(43) Date of publication of application: **25.03.2026**
(21) Application number: 25188428.4
(22) Date of filing: 09.07.2025
(51) Int. Cl.: H10W 74/40

(54) **SEMICONDUCTOR WAFER WITH WAFER PROTECTION MATERIAL WITH LUMINESCENT BASED ADDITIVES**

(30) Priority: 18.09.2024 US 202418888219
(71) Applicant: INTEL Corporation, Santa Clara, CA 95054 (US)
(72) Inventor: CRIST, Jordan, Newberg, 97132 (US); CUMMINGS, Lauren, Hillsboro, 97123 (US); KRISHNATREYA, Bhaskar Jyoti, Beaverton, 97007 (US); PATEL, Jigneshkumar, Chandler (US); RENAVIKAR, Mukul, North Plains, 97133 (US); ZHOU, Zhe, Tigard, 97224 (US)
(74) Representative: Viering, Jentschura & Partner mbB Patent- und Rechtsanwälte

(57) **Abstract**

In the various aspects, a wafer protection/coating material is provided with luminescent additives and is deposited over a BGA or a plurality of solder bumps as a protective layer during a laser scribe, a laser full cut, and/or plasma singulation process. The inclusion of luminescent additives facilitates assessing, in-line, the coating quality, i.e., thickness, specifically the coverage of the wafer protection material on top of the solder bumps using luminescent detection metrology. In an aspect, the wafer protection material may be water-soluble and may be removed after the laser/plasma process step using water.

## Description

### Background

For integrated circuit design and fabrication, the need to improve performance and lower costs are constant challenges. Various testing techniques are used during the semiconductor manufacturing process, such as functional testing for the basic functions of integrated circuits (ICs), structural testing for identifying physical defects, parametric testing for analyzing the performance of a die under varying conditions, and reliability testing for assessing the durability and longevity of the die.

Presently, there is no inline metrology or testing method to assess the quality of a wafer protection/coating material layer for solder bumps or copper (Cu) pads/pillars. At the wafer level, a plurality of solder bumps or CU pillars may serve as the primary medium of contact between the die and the package substrate. A wafer protection material may be deposited over the solder bumps as a protective/passivation layer for back-end processing steps. Poor coating quality may pose downstream process risks to the solder bumps or CU pillars (i.e., allowing the solder bumps to be damaged, for example, by laser debris), which, for example, may contribute to capillary underfill delamination, thermal compression bonding yield losses, and reliability failures. A non-destructive testing procedure for the wafer protection layer may provide improved yields and reliability.

### Brief Description of the Drawings

In the drawings, like reference characters generally refer to the same parts throughout the different views. The drawings are not necessarily to scale, emphasis instead generally being placed upon illustrating the principles of the present disclosure. The dimensions of the various features or elements may be arbitrarily expanded or reduced for clarity. In the following description, various aspects of the present disclosure are described with reference to the following drawings, in which:
FIG. 1 shows an exemplary representation of providing metrology measurements for a semiconductor wafer using an optical tool according to an aspect of the present disclosure;
FIG. 2 shows a simplified flow diagram for an exemplary calibration method for a layer of wafer protection material with a luminescent additive on a plurality of solder bumps according to an aspect of the present disclosure;
FIGS. 3A through 3E show exemplary representations of a wafer protection material with a luminescent additive being deposited on a semiconductor wafer having a plurality of solder bumps and the use of metrology measurements for adjusting the thickness of the coating material according to an aspect of the present disclosure;
FIG. 4 shows a simplified flow diagram for inline metrology measurements of a semiconductor according to an aspect of the present disclosure;
FIGS. 5A through 5D show exemplary representations of the use of a wafer protection material with a luminescent additive and metrology measurement therefor during high-volume manufacturing according to an aspect of the present disclosure; and
FIG. 6 shows an exemplary plot of a wafer protection material thickness as a function of the intensity of the fluorescence detected from the luminescent additive in the wafer protection material according to another aspect of the present disclosure.

### Detailed Description

The following detailed description refers to the accompanying drawings that show, by way of illustration, specific details, and aspects in which the present disclosure may be practiced. These aspects are described in sufficient detail to enable those skilled in the art to practice the present disclosure. Various aspects are provided for devices, and various aspects are provided for methods. It will be understood that the basic properties of the devices also hold for the methods and vice versa. Other aspects may be utilized and structural, and logical changes may be made without departing from the scope of the present disclosure. The various aspects are not necessarily mutually exclusive, as some aspects can be combined with one or more other aspects to form new aspects.

According to the present disclosure, a wafer protection/coating material is provided with luminescent additives and is deposited over a plurality of solder bumps or CU pads/pillars as a protective layer during a laser scribe, a laser full cut, and/or plasma singulation process. The inclusion of luminescent additives facilitates in assessing the coating quality, i.e., thickness, specifically the coverage of the wafer protection material on top of the solder bumps using luminescent detection metrology. In an aspect, the wafer protection material may be water-soluble and may be removed after the laser/plasma process step using water. Consequently, any residues of the wafer protection material on a die or wafer may be detected using the same luminescent detection metrology.

The present disclosure provides a wafer protection material including a polymer and a luminescent additive, and the wafer protection material is disposed over solder bumps on semiconductor wafers as a protective layer. In an aspect, the wafer protection may be a water-soluble polymer.

The present disclosure is further directed to a semiconductor wafer having a surface with a plurality of solder bumps and a wafer protection material including a polymer with a luminescent additive disposed over the plurality of solder bumps, whereby the wafer protection material provides a protective layer for the plurality of solder bumps.

The present disclosure is also directed to a method that includes providing a semiconductor wafer having a plurality of solder bumps, depositing a layer of wafer protection material containing a luminescent additive over the plurality of solder bumps; and performing one or more steps for a singulation of the semiconductor wafer.

The technical advantages of the present disclosure include, but are not limited to:
(i) providing an inline metrology for measuring the thickness of a protective layer covering solder bumps and assessing the quality of coverage;
(ii) providing a unique wafer protection material with a luminescent additive that may be used to determine the thickness of a protective layer formed using the wafer protection material; and
(iii) providing improved protection for solder bumps during backend process steps.

To more readily understand and put into practical effect the present wafer protection material having a luminescent additive and metrology methods, which may provide improved solder bump protection, particular aspects will now be described by way of examples provided in the drawings that are not intended as limitations. The advantages and features of the aspects herein disclosed will be apparent through reference to the following descriptions relating to the accompanying drawings. Furthermore, it is to be understood that the features of the various aspects described herein are not mutually exclusive and can exist in various combinations and permutations. For the sake of brevity, duplicate descriptions of features and properties may be omitted.

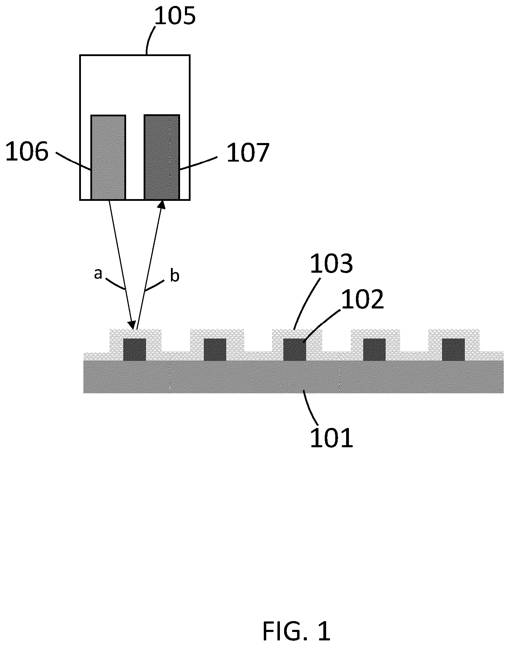

FIG. 1 shows an exemplary representation of providing metrology measurements for a semiconductor wafer 101 using an optical tool 105 according to an aspect of the present disclosure. In this aspect, the semiconductor wafer 101 may include a plurality of contact points or solder bumps 102, which may have a protective layer 103 composed of wafer protection material with a luminescent additive. The protective layer 103 is required to have sufficient coverage and thickness, i.e., a threshold thickness, especially on the plurality of solder bumps 102, to protect them during the backend processes, such as laser scribing, and laser or plasma cutting for singulation of the dies. In an aspect, the protective layer 103 of wafer protection material should have at least a threshold thickness, i.e., a thickness capable of surviving all of the backend processes, which may depend, in part, on the size of the wafer and devices thereon and may be in the range of approximately greater than zero to 100,000 nanometers.

In an aspect, the selection of the present fluorescent additive may be determined by their compatibility with the wafer protection material, i.e., polymer compatibility, the requirements of the metrology tool hardware, i.e., tool compatibility, the effects of the cleaning and coating processes, i.e., process compatibility, environmental health and safety standards, and cost considerations. In addition, the fluorescent additives may be specifically chosen for their ability to absorb an excitation wavelength provided by a designated optical/metrology tool and to emit a wavelength that can be detected by the tool's sensors, i.e., tool compatibility.

In another aspect, the metrology may be performed by the optical tool 105 (e.g., a fluorescence microscope), having a light source 106 (e.g., an LED light or arc lamp), and a detector 107 (e.g., fluorometer, probe, or camera). In particular, as shown in FIG. 1, the luminescent additives in the protective layer 103 may be illuminated with light "a" of a specific wavelength or wavelengths from the light source 106 and emitted light "b" from the luminescent additive detected/measured by the detector 107. A low luminous intensity may indicate insufficient coverage by the wafer protection material on the tops of the solder bumps and/or passivation layer, which may be potentially attributed to formulation issues or an inadequate wafer protection recipe.

In an aspect, the metrology for the protective layer 103 may be performed insitu and/or inline as part of a high volume manufacturing (HVM) process. The present method may avoid the need for ex-situ and/or destructive measuring techniques for determining the thickness of the protective layer 103.

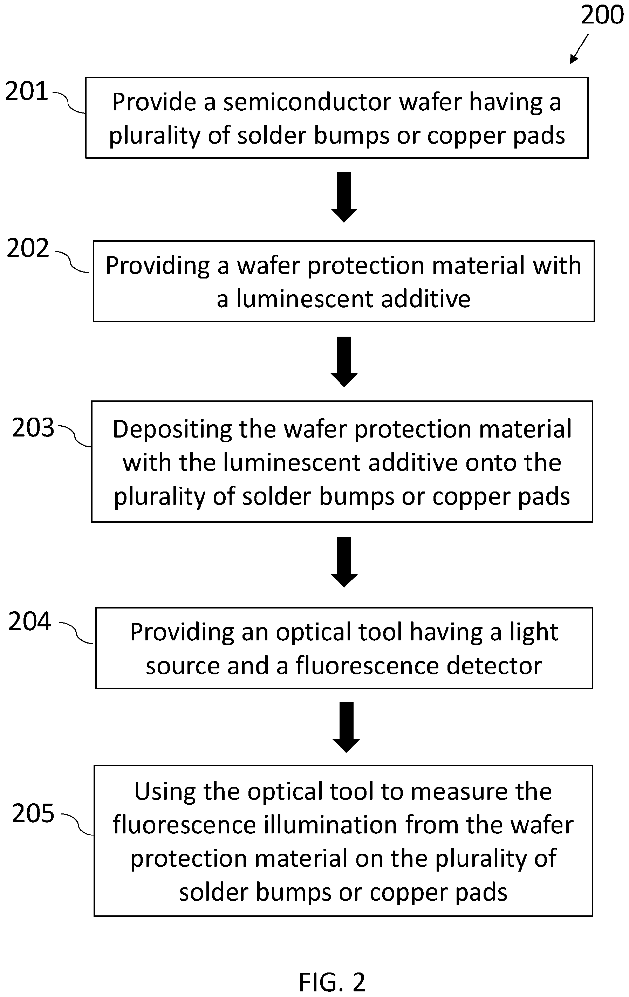

FIG. 2 shows a simplified flow diagram for an exemplary calibration method 200 for a layer of wafer protection material with a luminescent additive deposited on a plurality of solder bumps according to an aspect of the present disclosure.

The operation 201 may be directed to providing a semiconductor wafer having a plurality of solder bumps or CU pads. The plurality of solder bumps may be placed on the backside of the semiconductor wafer, which may placed thereon by conventional solder bump placement techniques.

The operation 202 may be directed to providing a wafer protection material with a luminescent additive. The wafer protection material may be made of an organic polymer, which may include polyvinyl alcohol, polyvinyl pyrrolidone, polyvinyl acetate, and nanocellulose. In an aspect, the wafer protection material may be a blend of water-soluble polymers, a variety of functional additives, and a carrier solvent. The luminescent additive may be made from luminescent materials or nanocrystals, e.g., fluorescent and phosphorescent additives, which may include organic dyes, metal complexes, and mixtures thereof. In an aspect, the luminescent additive may have a formulation in the range of approximately greater than zero to 99 percent by weight of the wafer protection material. In another aspect, the luminescent additive may emit light with a wavelength in the range of approximately 350 to 1000 nm.

The operation 203 may be directed to depositing the wafer protection material with the luminescent additive onto the plurality of solder bumps. The deposition may be performed using conventional deposition techniques, including spin coating, spray coating, slit coating, sputtering, thermal evaporation, chemical vapor deposition (CVD, and atomic layer deposition (ALD).

The operation 204 may be directed to providing an optical tool having a light source and a fluorescence detector. The optical tool may include a variety of optical detectors including UV-Vis absorption detectors, fluorescence detectors (e.g., fluorescence microscopes), and refractive index detectors.

The operation 205 may be directed to using the optical tool to measure the fluorescence illumination from the wafer protection material on the plurality of solder bumps. The plurality of solder bumps on the semiconductor wafer may be scanned using a preprogrammed pattern (e.g., raster scanning).

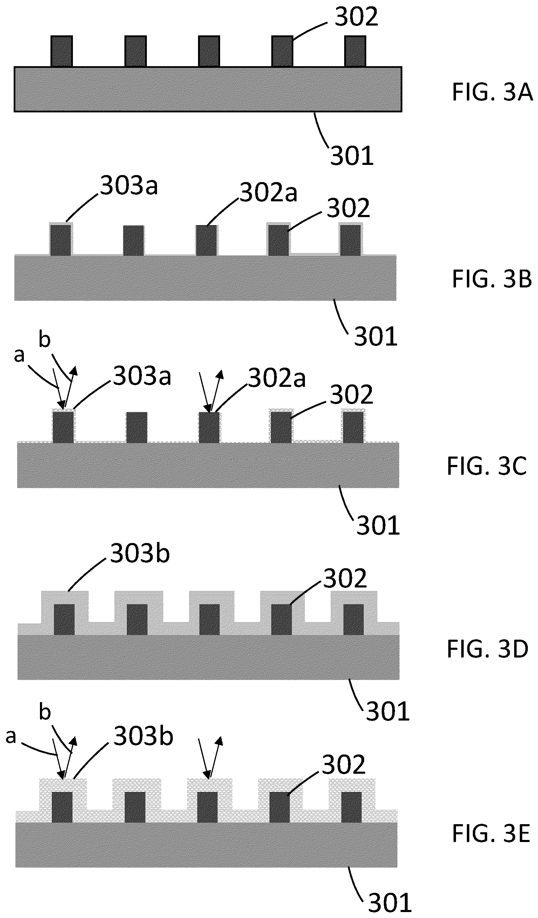

FIGS. 3A through 3E show exemplary representations of a wafer protection material with a luminescent additive being deposited on a semiconductor wafer having a plurality of solder bumps and the use of metrology measurements for adjusting the thickness of the wafer protection material according to an aspect of the present disclosure.

In this aspect, as shown in FIG. 3A, a semiconductor wafer 301 may be provided with a plurality of solder bumps 302. In FIG. 3B, a wafer protection material with a luminescent additive may be deposited as a protective layer 303a over the semiconductor wafer 301 and the plurality of solder bumps 302, but, for a variety of possible reasons, the coverage by the protective layer 303a may be partly or completely deficient in covering, for example, a top surface 302a of one of the plurality of solder bumps 302. In FIG. 3C, a present fluorescence metrology may be performed by having an optical tool (not shown) provide a source light "a" and measure an emitted light "b" from the wafer protection material to measure the thickness of the protective layer 303a.

In FIG. 3D, a new or additional protective layer 303b may be provided for the semiconductor wafer 301 and the plurality of solder bumps 302. In FIG. 3E, the present fluorescence metrology may be used again by having an optical tool (not shown) provide a source light "a" and measure an emitted light "b" from the wafer protection material to measure the thickness of the protective layer 303b and ensure that it is sufficiently thick and the coverage is complete.

It should be understood that the scheme is represented by FIGS. 3A through 3E may be directed to a calibration process to determine the thickness of a protective layer for a plurality of solder bumps of a particular dimension, i.e., adjusting the deposition recipe to a determined threshold thickness, or as a remediation process to correct the thickness of a protective layer.

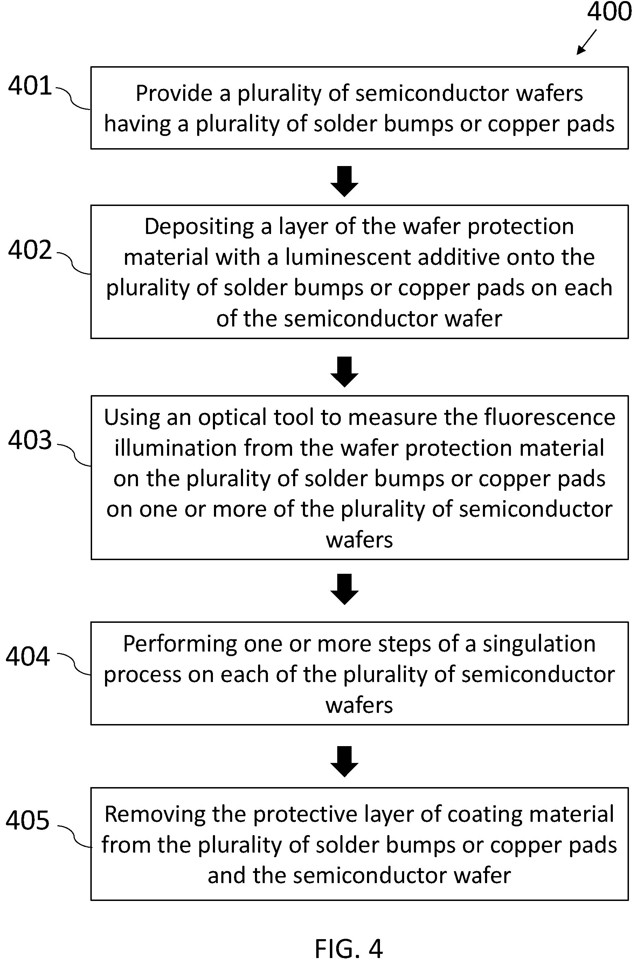

FIG. 4 shows a simplified flow diagram for inline metrology measurements of a semiconductor during a high-volume manufacturing process 400 according to an aspect of the present disclosure.

The operation 401 may be directed to providing a plurality of semiconductor wafers having a plurality of solder bumps or copper pads.

The operation 402 may be directed to depositing a layer of the wafer protection material with a luminescent additive onto the plurality of solder bumps or copper pads on each of the semiconductor wafers.

The operation 403 may be directed to using an optical tool to measure the fluorescence illumination from the wafer protection material on the plurality of solder bumps or copper pads on one or more of the plurality of semiconductor wafers.

The operation 404 may be directed to performing one or more steps of a singulation process on each of the plurality of semiconductor wafers.

The operation 405 may be directed to removing the protective layer of wafer protection material with the luminescent additive from the plurality of solder bumps or copper pads and the semiconductor wafer. A water-soluble wafer protection material may be removed using a water solution.

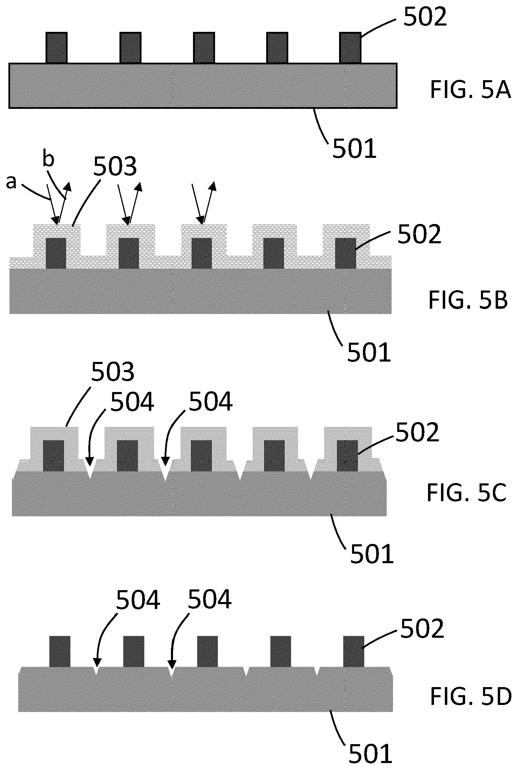

FIGS. 5A through 5D show exemplary representations of the use of a wafer protection material with a luminescent additive and metrology measurements during a high-volume manufacturing process according to an aspect of the present disclosure.

In this aspect, as shown in FIG. 5A, a semiconductor wafer 501 may be provided with a plurality of solder bumps 502. In FIG. 5B, a wafer protection material with a luminescent additive may be deposited as a protective layer 503 over the semiconductor wafer 501 and the plurality of solder bumps 502, and a present fluorescence metrology may be used by having an optical tool (not shown) provide a source light "a" and measure an emitted light "b" from the wafer protection material to measure the thickness of the protective layer 503 to ensure that it is sufficient. In FIG. 5C, a laser scribe step may be performed, whereby a laser beam is focused on the semiconductor wafer 501 to thermally ablate an incision 504. In FIG. 5D, the protective layer 503 of wafer protection material with the luminescent additive may be removed from the plurality of solder bumps 502 and the semiconductor wafer 501 by a conventional cleaning process, and the semiconductor wafer 501 may be cleaved along the incision 504.

In another aspect, the present fluorescence metrology may be used as a "check", as an inspection of a semiconductor wafer or die, to ensure that a protective layer made of the present wafer protection material having a luminescent additive has been completely removed by the cleaning process. If any residual wafer protection material is found, a further cleaning step may be used to remove such residual wafer protection material.

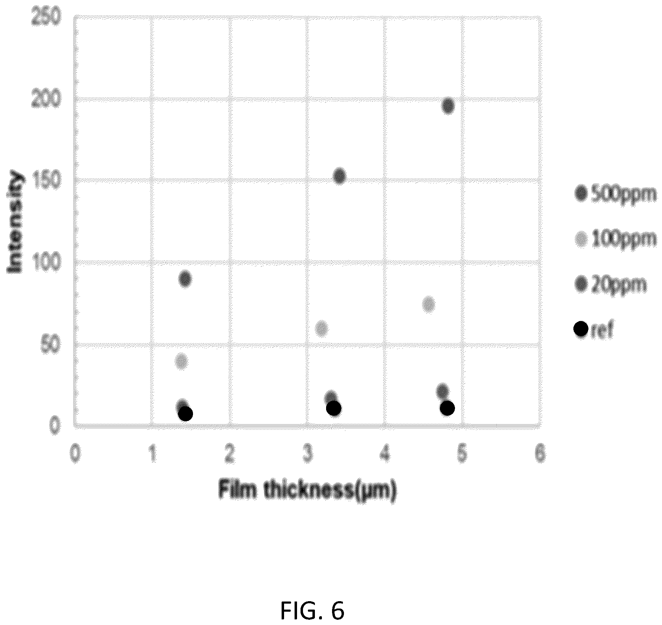

FIG. 6 shows an exemplary plot of a wafer protection material thickness as a function of the intensity of the fluorescence detected from the luminescent additive in the wafer protection material according to another aspect of the present disclosure. A wafer protection material made of an organic polymer, such as polyvinyl alcohol, polyvinyl pyrrolidone, polyvinyl acetate and nanocellulose, and a luminescent additive, such as boron-dipyrromethene compounds (BODIPY), 2H-chromen-2-one compounds (coumarins), 3,6-dihydroxy xanthene compounds (fluoresins), tetramethylindo(di)-carbocyanines compounds (cyanines), squaraine compounds, and other fluorophore compounds. In an aspect, a luminescent additive may be used that absorbs light in the range of approximately 511 to 551 nm and emits light in the range of approximately 573 to 613 nm. As shown in FIG. 6, the different formulations of the wafer protection material with varying amounts of luminescent additives, i.e., 0 ppm reference, 200 ppm, 100 ppm, and 500 ppm, were used and the relationship between coating thickness and luminous intensity was established. Additionally, it is possible to have the coat material formulation tailored for different applications, i.e., laser scribe, laser full cut, and plasma singulation applications.

It will be understood that any property described herein for a particular wafer protection material using a particular luminescent additive and metrology method for measuring the thickness of the protective layer formed using the present wafer protection material may also hold for any metrology method using the present wafer protection materials described herein. It will also be understood that any property described herein for a specific method may hold for any of the methods described herein. Furthermore, it will be understood that for any metrology tool and the methods for its use described herein, not necessarily all the components or operations described will be shown in the accompanying drawings or method, but only some (not all) components or operations may be disclosed.

To more readily understand and put into practical effect the present fluorescence metrology methods using a wafer protection material having a luminescent additive for semiconductor wafers having pluralities of solder bumps or CU pads, they will now be described by way of examples. For the sake of brevity, duplicate descriptions of features and properties may be omitted.

### Examples

Example 1 provides a semiconductor wafer having a surface of the semiconductor wafer with a plurality of contact points, and a wafer protection material including a polymer with a luminescent additive disposed over the plurality of solder bumps, for which the wafer protection material provides a protective layer for the plurality of contact points.

Example 2 may include the semiconductor wafer of example 1 and/or any other example disclosed herein, for which the polymer includes polyvinyl alcohol, polyvinyl pyrrolidone, polyvinyl acetate, and nanocellulose.

Example 3 may include the semiconductor wafer of example 1 and/or any other example disclosed herein, for which the luminescent additive includes boron-dipyrromethene compounds, 2H-chromen-2-one compounds, 3,6-dihydroxyxanthene compounds, tetramethylindo(di)-carbocyanine compounds, squaraine compounds, and fluorophore compounds.

Example 4 may include the semiconductor wafer of example 1 and/or any other example disclosed herein, for which the luminescent additive emits a light with a wavelength in a range of approximately 350 to 1000 nm.

Example 5 may include the semiconductor wafer of example 1 and/or any other example disclosed herein, for which the wafer protection material has a thickness in a range of approximately greater than zero to 100,000 nm.

Example 6 may include the semiconductor wafer of example 1 and/or any other example disclosed herein, for which the contact points comprise solder bumps, copper pads, or copper pillars.

Example 7 provides a method that includes providing a semiconductor wafer having a plurality of solder bumps, depositing a layer of wafer protection material containing a luminescent additive over the plurality of solder bumps, providing in-line metrology to measure a thickness of the layer of wafer protection material on the plurality of solder bump, and performing one or more steps for a singulation of the semiconductor wafer.

Example 8 may include the method of example 7 and/or any other example disclosed herein, which further includes removing the layer of wafer protection material containing the luminescent additive from over the plurality of solder bumps.

Example 9 may include the method of example 7 and/or any other example disclosed herein, which further includes providing an optical tool for measuring the thickness of the layer of wafer protection material on the plurality of solder bumps.

Example 10 may include the method of example 9 and/or any other example disclosed herein, for which the optical tool includes a light source and a luminescent light detector.

Example 11 may include the method of example 10 and/or any other example disclosed herein, for which measuring the thickness of the layer of wafer protection material at the plurality of solder bumps includes using the light source to irradiate the luminescent additive in the layer of wafer protection material at each of the plurality of solder bumps and using the luminescent light detector to measure a level of luminescent light generated by the luminescent additive in the layer of wafer protection material at each of the plurality of solder bumps.

Example 12 may include the method of example 7 and/or any other example disclosed herein, which further includes depositing an additional layer of wafer protection material over the plurality of solder bumps to provide an additional thickness for the layer of the wafer protection material over the plurality of solder bumps.

Example 13 may include the method of example 11 and/or any other example disclosed herein, which further includes measuring the thickness and the additional thickness of the layer of wafer protection material on the plurality of solder bumps.

Example 14 may include the method of example 12 and/or any other example disclosed herein, which further includes adjusting the depositing of the layer of wafer protection material containing the luminescent additive over the plurality of solder bumps to a threshold thickness.

Example 15 may include the method of example 12 and/or any other example disclosed herein, which further includes inspecting the plurality of solder bumps for any residuals of the layer of wafer protection material containing the luminescent additive.

Example 16 provides a wafer protection material that includes a polymer, and a luminescent additive, for which the luminescent additive is selected for compatibility with the polymer and detection by a designated tool, and for which the wafer protection material is disposed over solder bumps on a semiconductor wafer as a protective layer.

Example 17 may include the wafer protection material of example 16 and/or any other example disclosed herein, for which the polymer includes polyvinyl alcohol, polyvinyl pyrrolidone, polyvinyl acetate, and nanocellulose.

Example 18 may include the wafer protection material of example 16 and/or any other example disclosed herein, for which the luminescent additive includes a fluorescent additive and/or a phosphorescent additive.

Example 19 may include the wafer protection material of example 18 and/or any other example disclosed herein, for which the luminescent additive includes boron-dipyrromethene compounds, 2H-chromen-2-one compounds, 3,6-dihydroxy xanthene compounds, tetramethylindo (di)-carbocyanine compounds, squaraine compounds, and fluorophore compounds.

Example 20 may include the wafer protection material of example 18 and/or any other example disclosed herein, for which the luminescent additive emits a light with a wavelength in a range of approximately 573 to 613 nm.

The term "comprising" shall be understood to have a broad meaning similar to the term "including" and will be understood to imply the inclusion of a stated integer or operation or group of integers or operations but not the exclusion of any other integer or operation or group of integers or operations. This definition also applies to variations on the term "comprising" such as "comprise" and "comprises".

The term "coupled" (or "connected") herein may be understood as electrically coupled or as mechanically coupled, e.g., attached or fixed or attached, or just in contact without any fixation, and it will be understood that both direct coupling or indirect coupling (in other words: coupling without direct contact) may be provided.

The terms "and" and "or" herein may be understood to mean "and/or" as including either or both of two stated possibilities.

While the present disclosure has been particularly shown and described with reference to specific aspects, it should be understood by those skilled in the art that various changes in form and detail may be made therein without departing from the spirit and scope of the present disclosure as defined by the appended claims. The scope of the present disclosure is thus indicated by the appended claims and all changes which come within the meaning and range of equivalency of the claims are therefore intended to be embraced.

## Claims

1. A semiconductor wafer comprising:
a surface of the semiconductor wafer comprising a plurality of contact points; and
a wafer protection material comprising a polymer with a luminescent additive disposed over the plurality of solder bumps, wherein the wafer protection material provides a protective layer for the plurality of contact points.

2. The semiconductor wafer of claim 1, wherein the polymer comprises polyvinyl alcohol, polyvinyl pyrrolidone, polyvinyl acetate, and nanocellulose.

3. The semiconductor wafer of any one of claims 1 or 2, wherein the luminescent additive comprises boron-dipyrromethene compounds, 2H-chromen-2-one compounds, 3,6-dihydroxy xanthene compounds, tetramethylindo(di)-carbocyanine compounds, squaraine compounds, and fluorophore compounds.

4. The semiconductor wafer of any one of claims 1 to 3, wherein the luminescent additive emits a light with a wavelength in a range of approximately 350 to 1000 nm.

5. The semiconductor wafer of any one of claims 1 to 4, wherein the wafer protection material has a thickness in a range of approximately greater than zero to 100,000 nm.

6. The semiconductor wafer of any one of claims 1 to 5, wherein the contact points comprise solder bumps, copper pads, or copper pillars.

7. A method comprising:
providing a semiconductor wafer comprising a plurality of solder bumps;
depositing a layer of wafer protection material containing a luminescent additive over the plurality of solder bumps;
providing in-line metrology to measure a thickness of the layer of wafer protection material on the plurality of solder bump; and
performing one or more steps for a singulation of the semiconductor wafer.

8. The method of claim 7, further comprises removing the layer of wafer protection material containing the luminescent additive from over the plurality of solder bumps.

9. The method of any one of claims 7 or 8, further comprises providing an optical tool for measuring the thickness of the layer of wafer protection material on the plurality of solder bumps.

10. The method of claim 9, wherein the optical tool comprises a light source and a luminescent light detector.

11. The method of claim 10, wherein measuring the thickness of the layer of wafer protection material at the plurality of solder bumps comprises using the light source to irradiate the luminescent additive in the layer of wafer protection material at each of the plurality of solder bumps and using the luminescent light detector to measure a level of luminescent light generated by the luminescent additive in the layer of wafer protection material at each of the plurality of solder bumps.

12. The method of any one of claims 7 to 11, further comprises depositing an additional layer of wafer protection material over the plurality of solder bumps to provide an additional thickness for the layer of the wafer protection material over the plurality of solder bumps.

13. The method of any one of claims 11 or 12, further comprises measuring the thickness and the additional thickness of the layer of wafer protection material on the plurality of solder bumps.

14. The method of any one of claims 12 or 13, further comprises adjusting the depositing of the layer of wafer protection material containing the luminescent additive over the plurality of solder bumps to a threshold thickness.

15. The method of any one of claims 12 to 14, further comprises inspecting the plurality of solder bumps for any residuals of the layer of wafer protection material containing the luminescent additive.
